# EUROPEAN PATENT APPLICATION

(11) **EP 0 742 579 A2**
(43) Date of publication of application: **13.11.1996**
(21) Application number: 96303027.5
(22) Date of filing: 30.04.1996
(51) Int. Cl.: H01L 21/00

(54) **A method and apparatus for concentrating plasma on a substrate surface during processing**

(30) Priority: 11.05.1995 US 441160
(71) Applicant: APPLIED MATERIALS, INC., Santa Clara, CA 95054 (US)
(72) Inventor: Gupta, Anand, San Jose, California 95131 (US); Rana, Virendra V.S., Los Gatos, California 95032 (US)
(74) Representative: Bayliss, Geoffrey Cyril

(57) **Abstract**

A chuck assembly (10) for supporting a substrate (14) during processing in a plasma chamber, the substrate having a backside and a top side, the chuck assembly including a platform (12) having an upper portion (15) which has a substrate support surface (18) for receiving and supporting the substrate during processing, the support surface having an area that is substantially equal to the area of the backside of the substrate that is to be placed thereon; and an annular dielectric ring (30) around the upper portion of the platform, the annular ring having a central bore (34) that conforms to and is slightly larger than the outer perimeter of the upper portion (15) of the platform (12), the dielectric ring being made of a dielectric material having a dielectric constant that is less than the dielectric constant of the substrate.

## Description

The invention relates to a chuck assembly for use in a plasma processing system such as a plasma etch chamber.

A typical plasma chamber for etching a semiconductor wafer includes an anode and a cathode, which supports the wafer during the plasma etching process. A power source (e.g. an RF generator) is connected between the anode and the cathode. During processing, the power source generates a plasma above the wafer and a reactive gas (e.g. SF₆) that is introduced into the plasma etches the surface of the wafer.

In many conventionally designed plasma etch chambers, not all of the plasma current passes through the wafer substrate that is being etched. Some of it passes through other exposed parts of the cathode that supports the wafer. The plasma current that does not pass through the substrate does not aid in the etch process.

Modifications to the plasma chamber and cathode design have been offered to increase the efficiency of the etch process. For example, one modification has been to increase the size of the anode relative to the cathode so as to increase the plasma current. Another modification has been to add a focus ring above the cathode. The annular portion of the focus ring surrounds the outer perimeter of the wafer and the cathode supporting the wafer, and it typically rises above the surface of the wafer by 0.5 to 1 inch. The focus ring, which is made of an electrically insulating material (e.g. a ceramic), functions to concentrate gases more uniformly over the wafer itself.

We have discovered that the focus ring enhances particle trapping above the wafer during processing. The presence of the ring perturbs the electric field in the plasma such that the distorted field traps negatively charged particles between the plasma sheath and the glow region. When particle trapping occurs, a substantial number of particles remain suspended above the wafer until the plasma is turned off. At that time, they shower down onto the substrate and contaminate the newly etched surface.

The chuck assembly constructed in accordance with the invention includes a metal pedestal that has a substrate support surface which is substantially the same size and shape as the substrate. Surrounding the support surface is a dielectric ring having a low dielectric constant (i.e., low relative to that of the substrate). Using a metal support surface that is the same size as the substrate assures a uniform coupling of the plasma over the entire surface of the substrate. The dielectric ring next to the substrate functions to reduce coupling of the plasma coupling to noncritical areas outside of the perimeter of the substrate.

In general, in one aspect, the invention is a chuck assembly for supporting a substrate during processing in a plasma chamber. The chuck assembly includes a substrate platform having an upper portion and a lower portion. The upper portion of the platform has a substrate support surface for receiving and supporting the substrate during processing. The support surface has an area that is substantially equal to the area of the backside of the substrate that is to be placed thereon. The chuck assembly also includes an annular dielectric ring around the upper portion of the substrate platform. The annular ring has a central bore that conforms to and is slightly larger than the outer perimeter of the upper portion of the platform and hence of the substrate. In addition, the dielectric ring is made of a material having a dielectric constant that is less than the dielectric constant of the substrate.

In preferred embodiments, the top surface of the dielectric ring is at least as high as the substrate support surface of the platform. Preferably, the top surface of the dielectric ring is coplanar with the top side of the substrate when the substrate is being held on the support surface of the platform for processing.

In general, in another aspect, the invention is a chuck assembly including a substrate platform having a substrate support surface for receiving and supporting the substrate during processing, wherein the support surface has an area that is equal to the area of the backside of the substrate that is to be placed thereon.

In general, in yet another aspect, the invention is a method of supporting a substrate for processing in a plasma chamber. The method includes providing a substrate platform having an upper portion which has a substrate support surface for receiving and supporting the substrate during processing, surrounding the upper portion of the platform with an annular dielectric ring having a central bore that conforms to and is slightly larger than the outer perimeter of the upper portion of the substrate platform, and placing said substrate on the substrate support surface of the platform prior to generating a plasma above the substrate. The support surface has a shape and an area that is substantially equal to the shape and area of the backside of the substrate that is to be placed thereon. The substrate is placed on the support surface so that its perimeter is aligned with the perimeter of the support surface. In addition, the dielectric ring is made of a material having a dielectric constant that is less than the dielectric constant of the substrate.

The dielectric ring surrounding the platform prevents the plasma from coupling to regions outside of the area of the substrate and thereby concentrates the plasma onto the substrate. Because the invention concentrates the plasma onto the wafer, it enables one to achieve a substantially higher etch rate as compared to conventionally designed pedestals where some of the plasma is decoupled from the substrate during processing. Indeed, the etch achievable etch rates are higher than those that are achievable using focus rings. In addition, the coplanar surface that is formed by the surface of the substrate and the top of the ring produces minimal perturbation to the field above the substrate during processing and thus facilitates the flow of particles away from the surface of the substrate that is being etched. That is, the invention reduces or eliminates particle trapping and the deleterious consequences of particle trapping to device quality and chamber cleanliness.

The invention eliminates the need for using a focus ring to concentrate the gases onto the substrate during plasma etch processing. By eliminating the focus ring, one also eliminates the problems associated with using a focus ring, e.g. particle trapping. Thus, in comparison to a system that uses a focus ring, it also increases the number of substrates that may be processed in the plasma chamber before the chamber has to be cleaned of the contamination that is produced during plasma etching.

Other advantages and features will become apparent from the following description of the preferred embodiment with reference to the accompanying drawings, in which :
Fig. 1 is a cross-sectional side view of the substrate support platform for use in a plasma process chamber; and
Fig. 2 is top view of the chuck assembly showing the clamping ring.

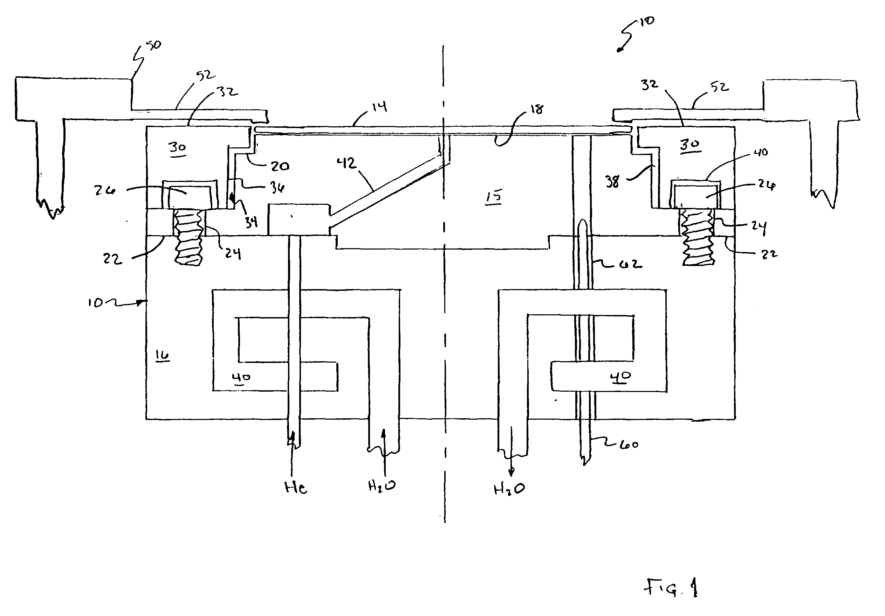

Referring to Fig. 1, a chuck assembly 10 that embodies the invention includes a metal pedestal 12 for supporting a substrate (e.g. a semiconductor wafer 14) during processing in a plasma chamber (not shown). The plasma chamber may be a plasma etch chamber, such as the 5000 Etch Chamber made by Applied Materials, Inc. of Santa Clara, California. When the chuck assembly is used in the plasma chamber, it serves as the cathode above which the plasma is formed. An electrode (e.g. anode) (not shown) is placed above and parallel to the pedestal and extends laterally generally to the extent of the pedestal. An RF source (not shown) connected between the anode and the cathode excites a plasma between the cathode and anode in a processing gas that is held at a set processing pressure.

Pedestal 12 is made up of an upper platform 15 that is bolted to a lower body portion 16, both of which are made of aluminum. Platform 12 is generally cylindrically shaped with a planar support surface 18 for receiving and supporting the wafer. The diameter of the top surface is substantially equal to the diameter of the wafers that are to be processed in the chamber (e.g. the diameter of the platform is equal to the diameter of the wafer to within ±1 or ±2 millimeters). Since wafers typically come in standard diameters of 4, 6, or 8 inches, the diameter of the top surface is selected to be substantially equal to one of these sizes depending upon which wafers will be processed in the chamber. Note that it is desirable top surface of the platform be slightly larger than the wafer rather than slightly smaller. If the top surface of the platform is slightly smaller than the wafer, the coupling of the plasma to the wafer around its outer perimeter will not be as good as it is to those areas of the wafer tha are directly above the platform top surface. This would tend to lead to a lower etch rate near the wafer perimeter. On the other hand, if the top surface of the platform is too much larger than the size of the wafer, the plasma will couple to the platform thereby defeating the purpose of the dielectric ring.

Note that if wafers with an alignment flat are to be processed in the system, then the profile of the top surface of platform 12 should also include a flat side so that the top surface closely conforms to the profile of the wafer.

Just below the top surface of platform 12, the cylindrically shaped platform increases slightly in diameter thereby forming a narrow ledge 20 around the outside of the platform. Located at the bottom end of the platform is a flange 22 with a set of bolt holes 24 at evenly spaced locations about its perimeter. Bolts 26 passing through the bolt holes in the flange are screwed into corresponding threaded holes in the lower body portion 16 and hold the upper platform and the lower body portion together.

A dielectric ring 30 rests on the pedestal flange 22 so that the ring surrounds the pedestal. Ring 30 has a flat top surface 32 that is parallel to and sightly above the top surface of the platform. When the ring is resting on the flange, its top surface 32 is substantially coplanar with the top surface of the wafer 14. Therefore, the thickness of the dielectric ring depends on the thickness of the wafers that are to be processed on that pedestal. For example, many 8 inch silicon semiconductor wafers typically have a thickness of about 1 millimeter. The thickness of the dielectric ring that is used with such wafers will be larger than the distance between the top of the flange and the top surface of the platform by about 1 mm ± 100 microns (i.e., 250 ± 25 mils).

The dielectric ring 30 is made of a material that has a dielectric constant that is less than the dielectric constant of the wafer, preferably much less. Any of a number of alternative materials can be used for the dielectric ring so long as it has the appropriate dielectric constant and it is compatible with the process being performed and the operating conditions in the chamber (e.g. polysulphone, Vespel, quartz, teflon, ceramics and plexiglass). In the described embodiment for processing silicon wafers, which have a dielectric constant of about 11 at the RF frequency of about 1 MHz, the dielectric constant of the ring is less than about 9.

The closer that the dielectric constant of the ring is to the dielectric constant of the wafer, the more the plasma will have a tendency to spread out over the ring. Conversely, the lower the dielectric constant of the ring is as compared to the dielectric constant of the wafer, the more the plasma will tend to be concentrated over the wafer and the less it will tend to spread over onto the ring.

The outer diameter of the dielectric ring 30 is larger than the diameter of the wafer 14 and at least as large as the diameter of the flange 22 and/or the lower body portion 16 of the pedestal, thereby shielding from the plasma the upper surfaces of the platform that are not covered by the wafer during processing. In the described embodiment, which is designed to etch 8 inch wafers, the outside diameter of the annular ring 30 and the flange 22 is about 10.5 inches.

Through the center of the dielectric ring is a bore 34 which has an inner wall 36. The bore is slightly larger than the outside dimensions of the pedestal so that it readily fits onto the generally cylindrically shaped pedestal. In addition, the inner wall 36 of the bore 34 is contoured so as to conform to the contour of the outside wall, of the platform 15 leaving only a small gap 38 between the dielectric ring 30 and the pedestal 10. In practice, the gap should be large enough so that assembly of the dielectric ring onto the pedestal is made easy, but it should not be so large as to permit the plasma to penetrate into the gap during plasma etching. In other words, it is desirable to have the gap be smaller than the thickness of the plasma sheath that will be present during etching. Since the thickness of the plasma sheath decreases with increasing chamber pressure, the maximum size of the gap will depend on the highest pressure at which the plasma etching system is expected to operate. In the described embodiment, which is operated in the 200-300 mTorr pressure range, the gap is less than about 10 mils (e.g. 5 to 7.5 mils) on average.

The dimensions of the ledge 20 formed around the outside of the pedestal are not critical. Its purpose is to create an obstruction or "jog" in the path proceeding deeper into the gap. The "jog" in the path further helps to discourage the plasma from penetrating down into the gap. This can be accomplished, for example, with a "jog" that is approximately 1/16 to 1/4 inch wide.

In the described embodiment, the bottom side of the dielectric ring 30 (i.e., the side which rests against the flange 22) has an annular groove 40 formed in it. The annular groove is aligned with the bolts, and it is both wide enough and deep enough to fit over the bolt heads when the dielectric ring is place down onto the pedestal flange. In this way, the bolts are concealed beneath the dielectric ring. The top surface 32 of the dielectric ring is thus flat and without any features or elements that might perturb the electric field above the pedestal during processing.

The thickness of the dielectric ring depends on its dielectric constant of the material. The lower the dielectric constant, the thinner the ring can be. In the described embodiment, the dielectric ring is between about 0.125 inches to 1 inch thick.

In comparison to the wafer, the dielectric ring presents a relatively nonconductive surface to the plasma in regions outside of the wafer. The plasma will tend to take the easiest path to the cathode, which is through the wafer rather than through the dielectric ring. Thus, the ring's presence on the platform induces the plasma current to more effectively couple to the cathode through the wafer, thereby concentrating the plasma above the wafer. Using a cathode having a planar surface that has the same shape and area as the wafer produces a more uniform electric field above the entire wafer thereby producing a more uniform etch rate over the surface of the wafer. By producing a coplanar surface, as defined by the top of the wafer and the top of the dielectric ring, perturbations to the electric field above the wafer are minimized thereby reducing or eliminating particle trapping and permitting the flow of the reactive gas (e.g. SF₆ for tungsten film etching) over the surface of the wafer to more effectively sweep away the debris that is being generated during the etch process.

It is important that the top surface of the platform on which the wafer rests has the same diameter as the wafer. If the diameter is larger than that of the wafer, some of the plasma current will pass through the regions of the platform that are not covered by the wafer, thereby reducing etching efficiency and generating additional contamination in the chamber. On the other hand, if the diameter of the platform is smaller than that of the wafer, the plasma will not be uniformly distributed over the surface of the wafer and thus etching will not be uniform over the entire substrate. More specifically, etching will be slower near the perimeter of the wafer than near the center of the wafer.

Focusing more of the plasma over the wafer and thus causing more of the plasma current to pass through the substrate increases the efficiency of the etching process up to as much as two times as compared to systems which do not include a dielectric ring (using the same power levels). Being able to focus the plasma in this way avoids the problems that accompany the use of a focus ring, e.g. particle trapping and the necessity of more frequent chamber cleanings.

Other features of the pedestal which is used in the plasma etch chamber are also shown in Fig. 1. The lower body portion 16 of the pedestal 10 includes a network of coolant channels 40 through which a coolant (e.g. water) may be pumped to cool the pedestal and the wafer during plasma etching. The upper platform 15 includes internal distribution channels 42 for conducting He gas to the backside of the wafer during processing. The He gas increases the thermal coupling between the backside of the wafer and the water-cooled pedestal thereby aiding in the cooling of the wafer.

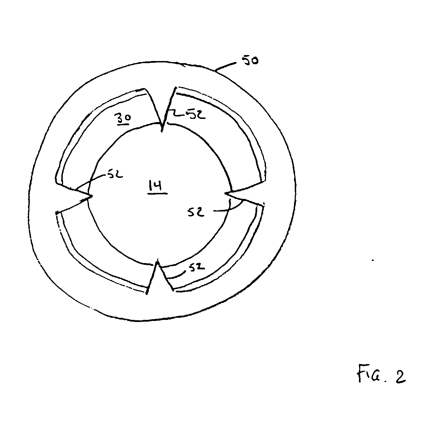

Referring to Figs. 1 and 2, if the pedestal is not an electrostatic chuck, it may also be necessary to use a clamping ring 50 that is lowered onto the chuck assembly to hold the wafer onto the pedestal against the positive pressure of the backside cooling gas. The clamping ring 50 is a thin quartz or plastic ring that has an inside opening of a diameter that is greater than the diameter of the wafer. Extending inwardly in a radial direction are four fingers 52 evenly spaced about the circumference of the clamping ring. The fingers 52 are long enough and configured so that they just contact the outer perimeter of the wafer when the ring is lowered onto the chuck assembly, thereby holding the wafer against the upper support surface of the pedestal. The fingers are the only portion of the clamping ring that contacts the upper surface of the substrate, thereby minimizing the area of the wafer surface that is affected by the clamping ring. In addition, the clamping ring is thin (e.g. about 0.125 inch) to minimize the perturbations which it will cause to the electric field above the wafer during plasma etching.

If an electrostatic chuck is used, a clamping ring may be unnecessary and the field perturbations caused by the presence of the clamping fingers can be avoided. In the case of an electrostatic chuck, typically the uppermost surface of the chuck is a dielectric layer and the underlying chuck electrode is often aluminum. These fit onto an aluminum pedestal cathode.

Also shown in Fig. 1 is one of four lift pins 60 within a corresponding lift pin hole 62 in the pedestal. A mechanical lifting device (not shown) raises the lift pins so as to lift the wafer off of the chuck assembly after processing is completed.

Though the described embodiment refers to plasma etch processing of a semiconductor wafer, the technique is not limited to use with semiconductor wafers nor is it limited to only being used with plasma etching. The invention can be used on any substrate which can be processed in a plasma chamber, whether it be an etch chamber or some other type of plasma chamber.

## Claims

1. A chuck assembly for supporting a substrate during processing in a plasma chamber, said substrate having a backside and a top side, said substrate characterized by a predefined area and shape and a dielectric constant, said chuck assembly comprising:
a platform having an upper portion and a lower portion, said upper portion having a substrate support surface for receiving and supporting the substrate during processing, said support surface having an area that is substantially equal to the area of the backside of the substrate that is to be placed thereon; and
an annular dielectric ring around the upper portion of the platform, said annular ring having a central bore that conforms to and is slightly larger than the outer perimeter of the upper portion of the platform, said dielectric ring made of a material having a dielectric constant that is less than the dielectric constant of the substrate.

2. The chuck assembly of claim 1 wherein the platform comprises an electrically conductive material.

3. The chuck assembly of claim 2 wherein the platform comprises a metal.

4. The chuck assembly of claim 3 wherein the platform comprises aluminum.

5. The chuck assembly of claim 2 wherein the dielectric ring has a flat top surface that lies in a plane.

6. The chuck assembly of claim 2 wherein the top surface of the dielectric ring is at least as high as the substrate support surface of the platform.

7. The chuck assembly of claim 6 wherein the top surface of the dielectric ring is above the substrate support surface of the platform.

8. The chuck assembly of claim 7 wherein the top surface of the dielectric ring as above the substrate support surface by an amount equal to about the thickness of the substrate to be placed thereon.

9. The chuck assembly of claim 7 wherein the top surface of the dielectric ring is coplanar with the top side of the substrate when the substrate is being held on the support surface of the platform for processing.

10. The chuck assembly of claim 2 wherein the central bore has an inner wall and the upper portion of the platform has an outer wall, and wherein the inner wall of the central bore and the outer wall of the platform define a gap around said platform, said gap having a width that is sufficiently small to prevent the plasma from entering the gap during processing.

11. The chuck assembly of claim 2 wherein a plasma is formed above the substrate during processing, said plasma having a plasma sheath, and wherein the central bore has an inner wall and the upper portion of the platform has an outer wall, and wherein the inner wall of the central bore and the outer wall of the platform define a gap around said platform, said gap having a width that is less than the thickness of the plasma sheath.

12. The chuck assembly of claim 11 wherein the central bore has an inner wall and the upper portion of the platform has an outer wall, and wherein the inner wall of the central bore and the outer wall of the platform define a gap around said platform, said gap having a width that is less than about 10 mils on average.

13. The chuck assembly of claim 6 wherein the dielectric constant of the dielectric ring is much less than the dielectric constant of the substrate.

14. The chuck assembly of claim 6 wherein the substrate is a silicon substrate and the dielectric constant of the ring is less than 11.

15. The chuck assembly of claim 14 wherein the dielectric constant of the ring is less than 9.

16. A chuck assembly for supporting a substrate during processing in a plasma chamber, said substrate having a backside and a top side, said substrate characterized by a predefined area and shape and a dielectric constant, said chuck assembly comprising:
a platform having a substrate support surface for receiving and supporting the substrate during processing, said support surface having an area that is substantially equal to the area of the backside of the substrate that is to be placed thereon.

17. A method of supporting a substrate for processing in a plasma chamber, said substrate characterized by a dielectric constant and having a backside with a predefined shape and area, said method comprising:
providing a platform having an upper portion and a lower portion, said upper portion having a substrate support surface for receiving and supporting the substrate during processing, said support surface having a shape and an area that is substantially equal to the shape and area of the backside of the substrate that is to be placed thereon, said upper portion and said support surface each having an outer perimeter;
surrounding the upper portion of the platform with an annular dielectric ring, said annular ring having a central bore that conforms to and is slightly larger than the outer perimeter of the upper portion of the platform, said dielectric ring made of a material having a dielectric constant that is less than the dielectric constant of the substrate;
placing said substrate on the substrate support surface of the platform, wherein the substrate is placed on the support surface so that its perimeter is aligned with the perimeter of the support surface; and
generating a plasma above the substrate.

18. The method of claim 17 wherein the platform comprises an electrically conductive material.

19. The method of claim 18 wherein the platform comprises a metal.

20. The method of claim 19 wherein the platform comprises a metal comprising aluminum.

21. The method of claim 18 wherein the dielectric ring has a flat top surface that lies in a plane.

22. The method of claim 18 further comprising supporting the dielectric ring so that its top surface is at least as high as the substrate support surface of the platform.

23. The method of claim 22 wherein the top surface of the dielectric ring is above the substrate support surface of the platform.

24. The method of claim 23 wherein the top surface of the dielectric ring is above the substrate support surface of the platform by an amount equal to about the thickness of the substrate to be placed thereon.

25. The method of claim 22 wherein the top surface of the dielectric ring is coplanar with the top surface of the substrate when the substrate is being held on the support surface of the platform for processing.

26. The method of claim 22 wherein the central bore has an inner wall and the upper portion of the platform has an outer wall, and wherein the inner wall of the central bore and the outer wall of the platform define a gap around said platform, said gap having a width that is sufficiently small to prevent the plasma from entering the gap during processing.

27. The method of claim 22 wherein the plasma has a plasma sheath, and wherein the central bore of the dielectric ring has an inner wall and the upper portion of the platform has an outer wall, and wherein the inner wall of the central bore and the outer wall of the platform define a gap around said platform, said gap having a width that is less than the thickness of the plasma sheath.

28. The method of claim 22 wherein the central bore of the dielectric ring has an inner wall and the upper portion of the platform has an outer wall, and wherein the inner wall of the central bore and the outer wall of the platform define a gap around said platform, said gap having a width that is less than about 10 mils on average.

29. The method of claim 22 wherein the dielectric constant of the dielectric ring is much less than the dielectric constant of the substrate.

30. The method of claim 22 wherein the substrate is a silicon substrate and the dielectric constant of the ring is less than 11.

31. The method of claim 30 wherein the dielectric constant of the ring is less than 9.
